# EUROPEAN PATENT APPLICATION

(11) **EP 4 485 017 A1**
(43) Date of publication of application: **01.01.2025**
(21) Application number: 22928962.4
(22) Date of filing: 22.12.2022
(51) Int. Cl.: G02B 5/20, F21S 2/00, F21V 7/30, F21V 9/35, F21Y 115/10, F21Y 115/30

(54) **WAVELENGTH CONVERSION MEMBER AND LIGHT EMITTING DEVICE**

(30) Priority: 25.02.2022 JP 2022027809
(71) Applicant: Niterra Co., Ltd., Nagoya-shi, Aichi 461-0005 (JP)
(72) Inventor: KIKUCHI Toshimitsu, Nagoya-shi, Aichi 461-0005 (JP); TSUTAI Yoshifumi, Nagoya-shi, Aichi 461-0005 (JP); ABE Takashi, Nagoya-shi, Aichi 461-0005 (JP)
(74) Representative: J A Kemp LLP
(86) International application number: PCT/JP2022/047270
(87) International publication number: WO 2023/162445

(57) **Abstract**

A wavelength-converting member 10, having a substrate 12, and a phosphor layer 14 which is disposed on the substrate 12, which includes phosphor particles 16 and a light-transmitting ceramic 18 for binding the phosphor particles 16 to one another and the substrate 12 to the phosphor particles 16, and which is provided with voids 20. The voids 20 are accompanied by fissures 22 each having an aspect ratio of 1:3 or greater in a cross-section orthogonal to the substrate 12.

## Description

### TECHNICAL FIELD

The present invention relates to a wavelength-converting member, and to a light-emitting device.

### BACKGROUND ART

There has been known a light-emitting device employing a wavelength-converting member that can convert light emitted by a light source such as an LED (light-emitting diode) or an LD (laser diode), serving as a light-emitting element, to light having a different wavelength by the mediation of a phosphor layer. In recent years, there have been increased applications employing an LD as a light source, which achieves high energy efficiency and is readily adaptable to downsizing and high input.

In a known phosphor layer, phosphor particles are dispersed in a resin, typically an epoxy resin or a silicone resin. However, since the LD locally emits high-energy light, degradation/deterioration of the resin due to heat generation may occur, conceivably resulting in a drop in performance of a light-emitting device.

Aiming to enhance heat resistance of such a wavelength-converting member, Patent Document 1 discloses a wavelength-converting member which contains a particulate phosphor material and a binder, wherein the binder can be prepared by causing to react at room temperature or heat-treating at 500°C or lower a binder material containing at least one species of the group consisting of an oxide precursor converting to the corresponding oxide through hydrolysis or oxidation, a silicate compound, silica, and amorphous silica.

### PRIOR ART DOCUMENTS

### PATENT DOCUMENTS

Patent Document 1: Japanese Patent Application Laid-Open (kokai) No. 2015-038960

### SUMMARY OF THE INVENTION

### PROBLEMS TO BE SOLVED BY THE INVENTION

In the wavelength-converting member disclosed in Patent Document 1, higher output of the light source can be easily attained by use of an inorganic binder as a binder forming the phosphor layer.

However, as the output of the light source increases, some problems occur. The problems include shortening of service life and breakage of a wavelength-converting member, such as a drop in performance due to heat generation or accumulation in the wavelength-converting member (i.e., a phosphor layer), delamination of a phosphor layer from a substrate sustaining the phosphor layer, etc.

The present invention has been made under such circumstances, and an object of the invention is to provide a wavelength-converting member and a light-emitting device, each having excellent durability to an increased energy of the light emitted from a light source.

### MEANS FOR SOLVING THE PROBLEMS

(1) The wavelength-converting member of the present invention for attaining the above object is directed to a wavelength-converting member, comprising a substrate, and a phosphor layer which is disposed on the substrate, which includes phosphor particles and a light-transmitting ceramic for binding the phosphor particles to one another and the substrate to the phosphor particles, and which is provided with voids, characterized in that the voids are accompanied by fissures each having an aspect ratio of 1:3 or greater in a cross-section orthogonal to the substrate.
   When the voids present in the phosphor layer are accompanied by fissures each having an aspect ratio of 1:3 or greater in a cross-section orthogonal to the substrate, thermal stress which is generated by heat accumulated in the phosphor layer can be relaxed by the voids and fissures, whereby the wavelength-converting member can exhibit excellent resistance to high-energy light emitted from a light source.
(2) Another characteristic feature of the wavelength-converting member of the present invention resides in that the fissures each have a width of 5 µm or less.
   Since the width of a fissure is as small as 5 µm or less, stress which is generated by heat accumulated in the phosphor layer can be relaxed, while a possible adverse effect on the light-emission characteristics of the phosphor layer is reduced.
(3) Still another characteristic feature of the wavelength-converting member of the present invention resides in that the fissures each have an area ratio of 5% or more and 10% or less of a vision field of 15 µm × 30 µm in an SEM image observed in any cross-section orthogonal to the substrate.
   Since the area ratio of the fissures is 5% or more and 10% or less of a vision field of 15 µm × 30 µm in an SEM image observed in any cross-section orthogonal to the substrate, possible cracking of the phosphor layer originating from the fissures and delamination of the phosphor layer from the substrate can be reduced. As a result, high-energy light emitted from a light source can be employed while the strength of the phosphor layer is maintained.
(4) Yet another characteristic feature of the wavelength-converting member of the present invention is that the voids have an area ratio of 5% or more and 15% or less of a vision field of 15 µm × 30 µm in an SEM image observed in any cross-section orthogonal to the substrate, the area of the voids not including the fissures.
   Since the voids have an area ratio (i.e., percent void) of 5% or more and 15% or less of a vision field of 15 µm × 30 µm in an SEM image observed in any cross-section orthogonal to the substrate, the area of the voids not including the fissures, propagation of the fissures can be terminated by the voids, even when propagation of the fissures starts by thermal stress generated by heat accumulated in the phosphor layer during irradiation with high-energy light emitted from a light source. Also, even when high-energy light emitted from a light source is employed, break-through of the light emitted from the light source can be suppressed to fall within an appropriate range.
(5) The light-emitting device of the present invention is directed to a light-emitting device, characterized by comprising a light-emitting element that can emit light having a wavelength falling within a specific range, and a wavelength-converting member as recited in any of (1) to (4) above.

By employing a wavelength-converting member having a phosphor layer in which the component light-transmitting ceramic is provided with fissures in a light-emitting device, the light-emitting device can be adapted to high-output light-emitting elements such as an LD. Such a light-emitting device can be employed as a laser light, a headlight, a laser projector, etc.

### ADVANTAGEOUS EFFECTS OF THE INVENTION

According to the present invention, a wavelength-converting member provided with excellent resistance to high-energy light emitted from a light source can be yielded.

### BRIEF DESCRIPTION OF THE DRAWINGS

[FIG. 1] A cross-section of a wavelength-converting member according to an embodiment of the present invention, showing an example of the structure as observed in the cross-section.
[FIG. 2] 2A to 2C, schematic views each showing the methods for measuring the length and width of a fissure according to an embodiment of the present invention.
[FIG. 3] 3A and 3B, conceptual views each showing a part of an example of the light-emitting device according to an embodiment of the present invention.
[FIG. 4] A flowchart showing an example of the wavelength-converting member production method according to an embodiment of the present invention.

### MODES FOR CARRYING OUT THE INVENTION

With reference to the drawings, an embodiment of the present invention will be described. For the purpose of easy understanding of the description, the same component elements are denoted by the same reference numerals in each drawing, and overlapping description will be omitted. Notably, in a configuration view, each component element is conceptually drawn, and the dimensions thereof are not based on an actually scale.

### [Configuration of wavelength-converting member]

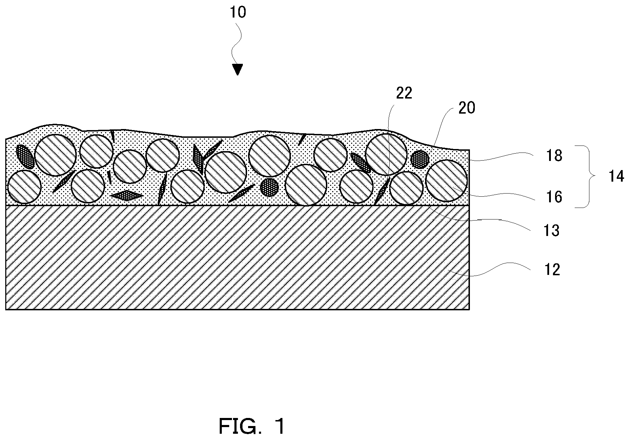

FIG. 1 is a cross-section of a wavelength-converting member 10 according to the present embodiment, showing an example of the structure as observed in the cross-section. In the wavelength-converting member 10 of the embodiment, a phosphor layer 14 is formed on a substrate 12. The wavelength-converting member 10 transmits or reflects incident light radiated from a light source, and also emits light having a wavelength modulated through excitation by incident light. For example, while blue incident light is transmitted or reflected, light having a wavelength converted to green, red, yellow, etc. in the phosphor layer 14 is emitted. Light of various colors can be realized through wavelength conversion, by combining the converted light and the incident light, or employing only the converted light.

The substrate 12 may have any of various shapes such as a circle, a rectangle, an ellipse, and a polygon, so long as the shape is fitted to the light-emitting device 40.

The material of the substrate 12 is appropriately selected in accordance with purpose of use. When the substrate is employed for transmitting excited light emitted from the light-emitting element, an inorganic material such as sapphire or glass may be used. Of these, sapphire, having high thermal conductivity, is particularly preferably used. In this case, accumulation of heat in the phosphor layer 14 is suppressed, whereby deterioration in characteristics of the phosphor particles 16 due to a rise in temperature can be suppressed. When the substrate is employed for reflecting excited light emitted from the light-emitting element, a metal such as aluminum, iron, or copper, or a ceramic may be used. Of these, aluminum is particularly preferably used, since aluminum has high thermal conductivity and high reflectance in the whole range of visible light. In this case, accumulation of heat in the phosphor layer 14 is suppressed, whereby deterioration in characteristics of the phosphor particles 16 due to a rise in temperature can be suppressed. On a main surface 13, which is the phosphor layer 14 side surface of the substrate 12, a material that can reflect light (e.g., silver) may be disposed through a technique such as plating or vapor deposition, to thereby form a reflection layer. Also, a reflection-enhancing layer may be formed from, for example, TiO₂.

The phosphor layer 14 is provided as a film on the substrate 12. The phosphor layer 14 is formed of the phosphor particles 16 and the light-transmitting ceramic 18 and includes the voids 20. The light-transmitting ceramic 18 binds the phosphor particles 16 to one another and the phosphor particles 16 to the substrate 12. In this configuration, the phosphor particles 16 join to the substrate 12, which functions as a heat-radiating member with respect to radiation of high energy-density light. As a result, efficient heat radiation can be achieved, whereby temperature quenching of the phosphor can be suppressed. The thickness of the phosphor layer 14 is preferably 15 µm or more and 300 µm or less, more preferably 50 µm or more and 200 µm or less.

The phosphor particles 16 may be formed of, for example, an yttrium aluminum garnet-type phosphor (a YAG-type phosphor) or a lutetium aluminum garnet-type phosphor (a LAG-type phosphor). Other than the two phosphors, the material of the phosphor particles 16 may be selected from the following members, in accordance with the color design of target emission. Examples of the phosphor material include blue phosphors such as BaMgAl₁₀O₁₇:Eu, ZnS:Ag,Cl, BaAl₂S₄:Eu, and CaMgSi₂O₆:Eu; Zn₂SiO₄:Mn, yellow or green phosphors such as (Y,Gd)BO₃:Tb, ZnS:Cu,Al, (M1)₂SiO₄:Eu, (M1) (M2)₂S:Eu, (M3)₃Al₅O₁₂:Ce, SiAlON:Eu, CaSiAlON:Eu, (M1)Si₂O₂N:Eu, and (Ba,Sr,Mg)₂SiO₄:Eu,Mn; yellow to orange or red phosphors such as (M1)₃SiO₅:Eu and (M1)S:Eu; and red phosphors such as (Y,Gd)BO₃:Eu,Y₂O₂S:Eu, (M1)₂Si₅N₈:Eu, (M1)AlSiN₃:Eu, and YPVO₄:Eu. In these chemical formulas, M1 includes at least one element selected from the group consisting of Ba, Ca, Sr, and Mg; M2 includes at least one of Ga and Al; and M3 includes at least one element selected from the group consisting of Y, Gd, Lu, and Te. Notably, the aforementioned materials of the phosphor particles 16 are merely examples, and the phosphor particles 16 employed in the wavelength-converting member 10 are not limited to the above examples.

The mean particle size of the phosphor particles 16 is preferably 5 µm or more and 50 µm or less, more preferably 7 µm or more and 30 µm or less. When the mean particle size is 5 µm or more, the emission intensity of the converted light increases, whereby the wavelength-converting member 10 can provide an increased emission intensity. When the mean particle size is 50 µm or less, the thickness of the phosphor layer 14 can be easily adjusted, whereby the risk of separation/removal of the phosphor particles 16 decreases. In addition, the temperature of the individual phosphor particles 16 can be maintained to be low, thereby suppressing temperature quenching. Notably, as used herein, The "mean particle size" refers to a median diameter (D50). The mean particle size may be determined by means of a laser diffraction/scattering particle size distribution meter in a dry or wet format.

The light-transmitting ceramic 18 is formed by hydrolyzing or oxidizing an inorganic binder and composed of a light-transmitting inorganic material. The light-transmitting ceramic 18 is formed of, for example, silica (SiO₂) or aluminum phosphate. Since the light-transmitting ceramic 18 has optical transparency, the ceramic allows light emitted from a light source (i.e., incident light) or converted light to transmit. Since the light-transmitting ceramic 18 is formed of an inorganic material, heat resistance increases, and deterioration can be prevented even when the ceramic is used under irradiation with high-energy light such as light emitted from an LD.

Examples of the inorganic binder which may be used in the invention include ethyl silicate and aqueous aluminum phosphate solution.

The term "light-transmitting substance (i.e., a substance having optical transparency)" refers to such a substance that, when a substance of interest (0.5 mm) is irradiated with incident light having a visible light wavelength (λ= 380 to 780 nm) toward a vertical direction, the radiation flux of light transmitted to the surface on the other side is higher than 80% that of the incident light.

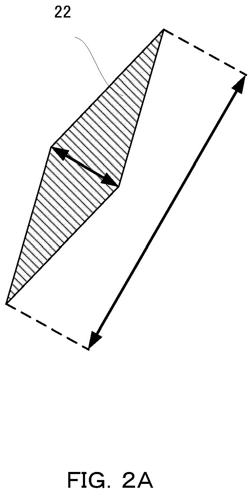

The voids 20 are provided between the phosphor particles 16 and the light-transmitting ceramic 18. The voids 20 are accompanied by fissures 22 each having an aspect ratio of 1:3 or greater in an SEM image observed in any cross-section orthogonal to the substrate 12. FIGs. 2A to 2C are schematic views each showing the methods for measuring the length and width of a fissure. As shown in FIG. 2A, the length of a fissure 22 corresponds to a length of a line connecting tips in the longitudinal direction of the fissure. The width of the fissure 22 corresponds to the maximum length thereof in a direction orthogonal to the longitudinal direction of the fissure (i.e., short direction). The width of the fissure 22 is preferably 5 µm or less. In this case, a risk of direct transmission of light emitted from a light source decreases. Thus, the stress generated by heat accumulated in the phosphor layer can be relaxed, while a risk of impairment of emission characteristics of the phosphor layer decreases.

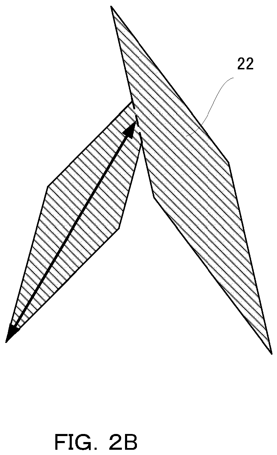

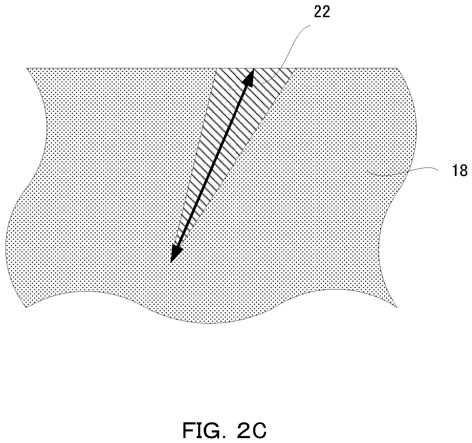

As shown in FIG. 2B, in the case where two fissures 22 are connected to each other, to thereby lose one tip, the length of the fissure 22 is defined as the length of a line connecting the remaining tip of the fissure 22 to the center of the joining face of the other fissure 22. As shown in FIG. 2C, when a fissure 22 is connected to the surface of the phosphor layer, the length of the fissure 22 is defined as the length of a line connecting the center of a line connecting two points of contact between the surface of the phosphor layer and the outer surface of the fissure to the tip of the fissure 22.

The area ratio of the fissures 22 having a width of 5 mm or less is preferably 5% or more and 10% or less of a vision field of 15 µm × 30 µm in an SEM image observed in any cross-section orthogonal to the substrate 12. In this case, possible cracking of the phosphor layer 14 originating from the fissures 22 and delamination of the phosphor layer 14 from the substrate 12 can be reduced. As a result, high-energy light emitted from a light source can be employed, while the mechanical strength of the phosphor layer 14 is maintained. The area ratio of the fissure 22 tends to increase by elevating the heat elevating rate in the belowmentioned heat treatment step.

The area ratio of the voids 20 with respect to a vision field of 15 µm × 30 µm in an SEM image observed in any cross-section orthogonal to the substrate 12 is preferably 5% or more and 15% or less, the area of the voids not including the fissures 22 having a width of 5 µm or less. In this case, even when propagation of the fissures 22 starts by thermal stress generated by heat accumulated in the phosphor layer 14 during irradiation with high-energy light emitted from a light source, propagation of the fissures 22 can be terminated by the voids 20. In addition, even when high-energy light emitted from a light source is employed, break-through of light emitted from the light source can be reduced to fall within an appropriate range. The area ratio of the voids 20 can fall within a specific range by modifying the ratio of a solvent or an inorganic binder added to the phosphor paste.

In addition to the phosphor particles 16 and the light-transmitting ceramic 18, the phosphor layer 14 may further contain additional inorganic particles. In incorporation of inorganic particles into the phosphor layer, inorganic particles suited for various purposes may be employed. Examples of the purpose include adjusting the viscosity of the phosphor paste, adjusting the phosphor particle density of the phosphor paste, scattering light in the phosphor layer, enhancing thermal conductivity of the phosphor layer, and reducing the number of voids in the phosphor layer. The mean particle size of the inorganic particles is preferably equivalent to or smaller than the mean particle size of the phosphor particles contained in the phosphor layer 14.

The area ratio of voids and that of fissures can be determined through, for example, the following procedure. Firstly, an SEM image is taken in any cross-section orthogonal to the substrate 12 at a magnification of 2,000. Then, the thus-obtained SEM image is subjected to image analysis such as binarization. In this procedure, the image employed for calculating the area ratio is preferably analyzed such that the area ratio values obtained from five vision fields selected at random are averaged so as to cover the entirety of the phosphor layer. Also, a plurality of cross-sectional images (e.g., 5 images) are preferably taken from the phosphor layer.

### [Configuration of light-emitting device]

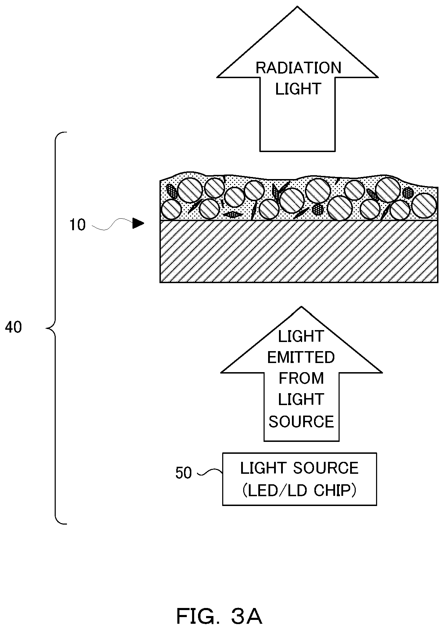

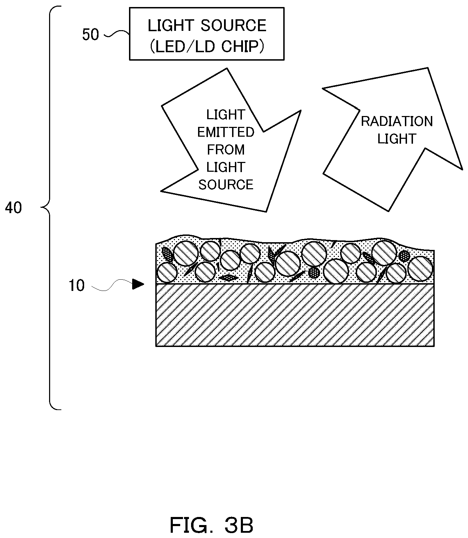

FIGs. 3A and 3B are schematic views showing a transmission-type light-emitting device and a reflection-type light-emitting device, respectively falling within the scope of the present invention. The light-emitting device 40 has a light source 50 and a wavelength-converting member 10. The light source 50 is a light-emitting element that can emit light having a specific wavelength from the light source, and an LED, an LD, or the like may be employed. Since the wavelength-converting member 10 achieves efficient wavelength conversion even when a high-power light source is employed, the light source 50 is preferably an LD.

### [Method of producing wavelength-converting member]

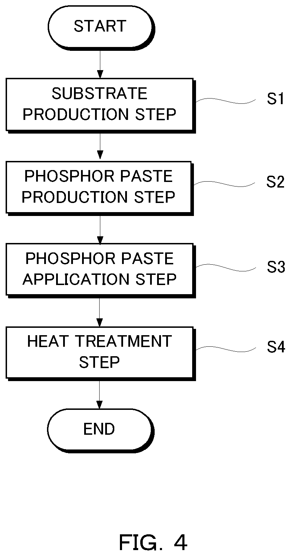

An example of the wavelength-converting member production method will be described. FIG. 4 is a flowchart showing the method of producing the wavelength-converting member of the present invention. Firstly, a substrate 12 having a specific shape suited for the purpose of use is formed (step S1).

In addition to the substrate 12, a phosphor paste is prepared by mixing phosphor particles 16 and an inorganic binder (step S2). In the preparation of the phosphor paste, firstly, phosphor particles having a specific mean particle size are provided. Various types of the phosphor particles 16 may be used in accordance with designing of the wavelength-converting member 10, and two or more types may be used. Next, the thus-provided phosphor particles 16 are weighed, dispersed in a solvent, and mixed with the inorganic binder, to thereby prepare a phosphor paste to be printed. In the procedure, the relative amount of a solvent or the inorganic binder added is tuned to adjust the area ratio of voids or fissures to fall within a corresponding range. More specifically, the volume of the binder in the phosphor layer to be formed is tuned to, for example, about 60% or less the phosphor particles, although the ratio varies depending on the type and concentration of the solvent or the inorganic binder. As a result, the area ratio of the voids or fissures successfully increases. Mixing may be conducted by means of a ball mill, a propeller agitator, or the like. In the case of a ball mill, the mixing time is preferably 3 minutes to 30 minutes. In the case of propeller agitation, the mixing time is preferably 5 minutes to 120 minutes. Through mixing, variation in the thickness of the phosphor layer can be reduced. As the solvent, high-boiling-point solvents such as α-terpineol, butanol, isophoron, and glycerin may be used.

Next, onto the surface of the substrate 12 produced in the substrate production step (step S1), the phosphor paste is applied, to thereby form a paste layer (step S3). Application of the phosphor paste may be conducted through screen printing, spraying, drawing with a dispenser, or inkjetting. Of these, screen printing is preferred, since a paste layer having a uniform thickness can be consistently formed. The thickness of the paste layer is adjusted so as to attain a target thickness after firing. The paste layer is preferably formed so as to follow the contour of the substrate 12.

Subsequently, the thus-applied phosphor paste is heattreated at 150°C or higher, to thereby form a phosphor layer (step S4). The heat treatment temperature is preferably 150°C or higher and 300°C or lower, particularly preferably 200°C or higher and 250°C or lower. In heat treatment, a holding time of 20 minutes or longer is preferably provided. The heat treatment time is preferably 0.5 hours or longer and 2.0 hours or shorter. The temperature elevation rate is preferably 2°C/min or more, more preferably 2°C/min or more and 10°C/min or less. The temperature elevation rate is appropriately tuned so as to adjust the area ratio of fissures to fall within a specific range. In one exemplary case, an increase in temperature elevation rate results in an increase in the area ratio of fissures, although the effect varies depending on the type and concentration of the solvent or the inorganic binder, the relative amount of addition, and the thickness of the phosphor paste. Also, a drying step may be provided before the heat treatment. The drying temperature is preferably 100°C or higher and 150°C or lower, and the drying time is more preferably 20 minutes or longer and 60 minutes or shorter.

### [Examples and Comparative Examples]

### (Fabrication of wavelength-converting member)

### (Example 1-1)

As a substrate, a disk-like substrate made of sapphire (diameter (φ) 50 mm, thickness (t) 0.5 mm) was provided.

In formation of a phosphor layer, a YAG-type phosphor (mean particle size: 15 µm), α-terpineol (solvent), and ethyl silicate (inorganic binder) were weighed, and the materials were mixed by means of a propeller agitator for 30 minutes, to thereby prepare a phosphor paste. The relative amount of the inorganic binder added was tuned by weighing such that the volume of the binder in the phosphor layer to be formed was adjusted to 60% with respect to the amount of the phosphor particles.

The thus-prepared phosphor paste was applied onto the substrate through screen printing so that the average thickness of the phosphor layer after the heat treatment was adjusted to 50 µm. The coated substrate was dried at 100°C for 20 minutes and then, subjected to a heat treatment in an non-oxidizing atmosphere by means of an electric furnace. The heating temperature was elevated to 150°C at a rate of 2°C/min, and the heat treatment was conducted at the temperature for 30 minutes, to thereby fabricate a wavelength-converting member of Example 1-1.

In the wavelength-converting member of Example 1-1, the area ratio of fissures having a width of 5 µm or less and the area ratio of the voids (excluding the fissures) in a vision field of 15 µm × 30 µm in an SEM image observed in any cross-section orthogonal to the substrate were determined. As a result, the area ratio of fissures and the area ratio of the voids (excluding the fissures) were found to be 5% and 10%, respectively.

### (Example 1-2)

The procedure of Example 1-1 was performed under the same conditions, except that the temperature elevation rate was modified to 5°C/min, to thereby fabricate a wavelength-converting member of Example 1-2. The area ratio of fissures and the area ratio of the voids (excluding the fissures) were found to be 7% and 9%, respectively.

### (Example 1-3)

The procedure of Example 1-1 was performed under the same conditions, except that the temperature elevation rate was modified to 10°C/min, to thereby fabricate a wavelength-converting member of Example 1-3. The area ratio of fissures and the area ratio of the voids (excluding the fissures) were found to be 10% and 8%, respectively.

### (Example 1-4)

The procedure of Example 1-1 was performed under the same conditions, except that the temperature elevation rate was modified to 1.5°C/min for reducing the area ratio of fissures to be smaller than that of Example 1-1, to thereby fabricate a wavelength-converting member of Example 1-4. The area ratio of fissures and the area ratio of the voids (excluding the fissures) were found to be 3% and 10%, respectively.

### (Example 1-5)

The procedure of Example 1-1 was performed under the same conditions, except that the temperature elevation rate was modified to 12°C/min for elevating the area ratio of fissures to be greater than that of Example 1-3, to thereby fabricate a wavelength-converting member of Example 1-5. The area ratio of fissures and the area ratio of the voids (excluding the fissures) were found to be 12% and 8%, respectively.

### (Example 2-1)

The procedure of Example 1-1 was performed under the same conditions, except that the relative amount of the inorganic binder to be added was changed to 90% for adjusting the area ratio of the voids (excluding the fissures) to be smaller than that of Example 1-1, to thereby fabricate a wavelength-converting member of Example 2-1. The area ratio of fissures and the area ratio of the voids (excluding the fissures) were found to be 5% and 3%, respectively.

### (Example 2-2)

The procedure of Example 1-1 was performed under the same conditions, except that the relative amount of the inorganic binder to be added was changed to 50% for adjusting the area ratio of the voids (excluding the fissures) to be greater than that of Example 1-1, to thereby fabricate a wavelength-converting member of Example 2-2. The area ratio of fissures and the area ratio of the voids (excluding the fissures) were found to be 5% and 18%, respectively.

### (Delamination test of phosphor layer)

Each of the above-produced wavelength-converting members was irradiated with light emitted from a light source at different levels A to C for 60 minutes. Delamination of a phosphor layer was checked. The light emitted from the light source, which was a blue LD, had a wavelength of 450 nm. The output levels were 0.5 W (level A), 1.0 W (level B), and 2.0 W (level C). Irradiation was conducted from the weak level to the strong level in laser light output. At the timing when delamination occurred, the test of the phosphor layer in the trial was finished.

**[Table 1]**

| | Area ratio of fissures | Area ratio of voids | Delamination of phosphor layer | | | Emission score |
|---|---|---|---|---|---|---|
| | | | Level A | Level B | Level C | |
| Example 1-1 | 5% | 10% | No | No | No | 3% |
| Example 1-2 | 7% | 9% | No | No | No | 4% |
| Example 1-3 | 10% | 8% | No | No | No | 4% |
| Example 1-4 | 3% | 11% | No | No | Yes | 3% |
| Example 1-5 | 12% | 8% | No | Yes | - | 5% |
| Example 2-1 | 5% | 3% | No | No | Yes | 2% |
| Example 2-2 | 5% | 18% | No | No | No | 8% |

As shown in Table 1, no delamination of the phosphor layer occurred in the Examples through irradiation with light emitted from a light source at a level A. In Examples 1-1 to 1-4, and 2-1 to 2-2, no delamination of the phosphor layer occurred through irradiation with light emitted from a light source at a level B. In contrast, in Example 1-5, the phosphor layer was partially defoliated through irradiation with light emitted from a light source at a level B. Conceivably, since the area ratio of fissures was high in Example 1-5, the strength of the phosphor layer itself decreased, to thereby cause delamination of the phosphor layer by high-energy light emitted from a light source.

In Examples 1-1 to 1-3 and 2-2, no delamination of the phosphor layer occurred through irradiation with light emitted from a light source at a level C. In contrast, in Examples 2-1 and 1-4, the phosphor layer was partially defoliated through irradiation with light emitted from a light source at a level C. Conceivably, since the area ratio of fissures was low in Example 1-4, delamination of the phosphor layer occurred from a part where sufficient relaxation of thermal stress by fissures was not achieved at a higher output of light emitted from a light source. Also conceivably, since the area ratio of voids was low in Example 2-1, delamination of the phosphor layer occurred as a result of propagation of fissures in a part having few voids at a higher output of light emitted from a light source.

### (Emission performance test)

The wavelength-converting member 10 was irradiated with blue LD laser (wavelength: 450 nm) as laser light with an output of 0.5 W. The chromaticity of light transmitted to the face opposite the incident side face was determined by means of a spectroradiometer (CL-500A, product of Konica Minolta, Inc.). In each Example, chromaticity was measured at 5 points, and the values were averaged.

Chromaticity is defined as a numerical index for color characteristics including hue, chroma, and brightness (but excluding brightness). In the present specification, chromaticity is represented by an international representation defined by Commission Internationale de l'Eclairage (CIE) in 1931, with a combination of (x,y) according to an X-Y chromaticity chart based on the CIE-XYZ color system. In the X-Y chromaticity chart, the greater the x-axis value, the greater the ratio of "red" sense. The smaller the x-axis value, the greater the ratio of "blue" sense. The greater the y-axis value, the greater the ratio of "green" sense. The smaller the y-axis value, the greater the ratio of "blue" sense. Also, the position corresponding to x=y=1/3 is called a "white point."

In determination of emission performance, the maximum value and average value of the deviation of chromaticity measurements in the X-axis direction were calculated. When the maximum value of the deviation in the X-axis direction was 10% or less the average value of the deviation in the X-axis direction, the score was "good." When the ratio was 5% or less, the score was "excellent emission performance."

As is clear from Table 1, in each of the Examples, the maximum value of the deviation in the X-axis direction was 10% or less the average value of the deviation in the X-axis direction. Also, in Examples 1-1 to 1-5 and 2-1, the maximum value of the deviation in the X-axis direction was 5% or less the average value of the deviation in the X-axis direction. Conceivably, since the area ratio of voids was high in Example 2-2, break-through of light emitted from a light source increased as compared with the other Examples, resulting in intense blue sensation.

As described above, in the wavelength-converting member of the present invention, thermal stress generated by heat accumulated in the phosphor layer during irradiation with high-energy light emitted from a light source was conceived to be relaxed by voids and fissures, to thereby provide excellent durability to against higher-energy light emitted from a light source. In addition, on the basis of suitable emission characteristics, possible adverse effect on the light-emission characteristics of the phosphor layer was found to be reduced by voids and fissures, to thereby relax the stress generated by heat accumulated in the phosphor layer.

Needless to say, the scope of the present invention is not limited to the aforementioned embodiment, and the present invention encompasses various modifications and equivalents falling within the concept and scope of the present invention. Furthermore, the structure, shape, number, location, dimensions, etc. of the essential elements shown in each drawing are provided for convenience for explanation, and these may be appropriately modified.

### Description of Reference Numerals

- 10:: wavelength-converting member
- 12:: substrate
- 13:: main surface
- 14:: phosphor layer
- 16:: phosphor particles
- 18:: light-transmitting ceramic
- 20:: void
- 22:: fissure
- 40:: light-emitting device
- 50:: light source

## Claims

1. A wavelength-converting member,
comprising a substrate, and a phosphor layer which is disposed on the substrate, which includes phosphor particles and a light-transmitting ceramic for binding the phosphor particles to one another and the substrate to the phosphor particles, and which is provided with voids,
**characterized in that** the voids are accompanied by fissures each having an aspect ratio of 1:3 or greater in a cross-section orthogonal to the substrate.

2. A wavelength-converting member according to claim 1, wherein the fissures each have a width of 5 µm or less.

3. A wavelength-converting member according to claim 2, wherein the fissures each have an area ratio of 5% or more and 10% or less of a vision field of 15 µm × 30 µm in an SEM image observed in any cross-section orthogonal to the substrate.

4. A wavelength-converting member according to claim 2 or 3, wherein the voids each have an area ratio of 5% or more and 15% or less of a vision field of 15 µm × 30 µm in an SEM image observed in any cross-section orthogonal to the substrate, the area of the voids not including the fissures.

5. A light-emitting device, **characterized by** comprising
a light-emitting element that can emit light having a wavelength falling within a specific range, and
a wavelength-converting member as recited in any of claims 1 to 4.
